(19) Europäisches Patentamt
European Patent Office
Office européen des brevets

(11) EP 2 832 514 A1

(12) **EUROPEAN PATENT APPLICATION**
published in accordance with Art. 153(4) EPC

(43) Date of publication:
04.02.2015 Bulletin 2015/06

(51) Int Cl.:
*B28B 3/26* (2006.01)    *C23C 14/06* (2006.01)
*C23C 14/48* (2006.01)

(21) Application number: 12873175.9

(22) Date of filing: 29.03.2012

(86) International application number:
PCT/JP2012/058360

(87) International publication number:
WO 2013/145209 (03.10.2013 Gazette 2013/40)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME

(71) Applicant: Ibiden Co., Ltd
Ogaki-shi, Gifu 503-8604 (JP)

(72) Inventors:
• ANDO Kiyotaka
  Anpachi-gun
  Gifu 503-2321 (JP)
• KAWANO Shuichi
  Anpachi-gun
  Gifu 503-2321 (JP)

(74) Representative: Hoffmann Eitle
Patent- und Rechtsanwälte PartmbB
Arabellastraße 30
81925 München (DE)

(54) **DIE FOR EXTRUSION MOLDING, PRODUCTION METHOD FOR DIE FOR EXTRUSION MOLDING, EXTRUSION MOLDING DEVICE, AND PRODUCTION METHOD FOR HONEYCOMB STRUCTURE**

(57) The die for extrusion molding of the present invention includes: a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole.

FIG.1

**Description**

TECHNICAL FIELD

The present invention relates to a die for extrusion molding, a method of producing a die for extrusion molding, an extruder, and a method of producing a honeycomb structured body.

BACKGROUND ART

Exhaust gases discharged from internal combustion engines of vehicles (e.g., buses, trucks) and construction machines contain particulate matter, such as soot. Particulate matter has been a problem as it is harmful to the environment and human body. Thus, various particulate filters which include honeycomb structured bodies formed of porous ceramic are proposed. Those filters purify exhaust gases by capturing particulate matter in exhaust gases.

For achieving excellent heat resistance and strength, such a honeycomb structured body includes a plurality of prismatic honeycomb fired bodies which are combined with one another with adhesive layers provided therebetween. The honeycomb fired bodies are produced by subjecting a mixture containing ceramic materials (e.g., silicon carbide) to, for example, extrusion molding, degreasing, firing, or other treatments.

Generally, in the production of honeycomb structured bodies, a molding raw material is extrusion molded through a die for extrusion molding to produce a honeycomb molded body including a large number of cells which are separated by cell walls and are arranged in parallel with one another in a longitudinal direction.

One of known dies for extrusion molding used to produce honeycomb molded bodies includes raw material supply sections for supplying a molding raw material and a lattice pattern of slit grooves for molding the molding raw material into a honeycomb molded body, the slit grooves communicating with the raw material supply sections.

For example, a die for extrusion molding in Patent Literature 1 includes supply sections and molding cap sections. The supply sections are provided with supply holes (raw material supply sections), and the molding cap sections are provided with molding grooves (slit grooves). Both the supply holes and the molding grooves are formed by drilling.

CITATION LIST

- Patent Literature

Patent Literature 1: JP H05-131425 A

SUMMARY OF INVENTION

- Technical Problem

After repeated extrusion molding of molding raw materials through the die disclosed in Patent Literature 1, the surfaces of the molding grooves of the die are likely to be worn away by abrasion due to contacts between molding raw materials and the molding grooves of the die. In particular, in the case where the molding raw material consists mainly of hard ingredients, such as silicon carbide powders, the surfaces of the molding grooves of the die are more likely to be worn away. Thus, extrusion molded honeycomb molded bodies have thick cell walls, reducing the dimensional accuracy. The die in such a condition cannot be appropriately used any more, and thus unfortunately has a shorter life.

The present invention is devised to solve the above problem, and aims to provide a die for extrusion molding, a method of producing a die for extrusion molding, an extruder, and a method of producing a honeycomb structured body that can achieve excellent abrasion resistance and a longer life of the die.

- Solution to Problem

A die for extrusion molding according to claim 1 is devised to achieve the above goal. The die includes a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole.

The nitride layer provided on an inner wall surface of the second through hole enhances the hardness of the inner wall surface of the second through hole.

This prevents abrasion of the inner wall surface of the second through hole even after repeated extrusion molding of molding raw materials. Thus, the life of the die can be increased.

An increase in the life of the die means preventing abrasion of the inner wall surface of the second through hole during use of the die to avoid an increase in the thickness of the cell walls of extrusion molded honeycomb molded bodies, and also means preventing uneven abrasion of the inner wall surface of the second through hole during use of the die to avoid uneven thickness of the cell walls of extrusion molded honeycomb molded bodies.

In a die for extrusion molding according to claim 2, the raw material supply section further has a first opening formed at the first face and a second opening formed at a part where the second through hole communicates with the first through hole, and the width of the raw material supply section decreases from the first opening toward the second opening.

If the width of the raw material supply section decreases from the first opening toward the second opening, a molding raw material readily flows from the raw material supply section to the molding section. Thus, the molding raw material is prevented from clogging in the die for extrusion molding.

In a die for extrusion molding according to claim 3, the molding section includes slit grooves that communicate with a plurality of the second through holes, the slit grooves connecting to one another to form a lattice pattern.

If the molding section includes slit grooves that communicate with a plurality of the second through holes, the slit grooves connecting to one another to form a lattice pattern, extrusion molding of a molding raw material through the die for extrusion molding enables a honeycomb molded body having a large number of cells that are separated by cell walls and are arranged in parallel with one another in a longitudinal direction.

In a die for extrusion molding according to claim 4, the raw material supply section further includes a nitride layer provided on an inner wall surface of the first through hole.

The nitride layer provided on the inner wall surface of the first through hole enhances the hardness of the inner wall surface of the first through hole. This prevents abrasion of the inner wall surface of the first through hole even after repeated extrusion molding of molding raw materials. Thus, the first through hole can maintain the shape that allows a molding raw material to readily flow from the raw material supply section to the molding section. As a result, the molding raw material is prevented from clogging in the die for extrusion molding even after repeated extrusion molding of molding raw materials.

In a die for extrusion molding according to claim 5, the nitride layer has a thickness of 5 to 1000 nm.

If the nitride layer has a thickness of 5 to 1000 nm, the inner wall surface of the second through hole can long maintain the abrasion resistance in the molding section. Thus, the life of the die can be further increased.

A nitride layer having a thickness of less than 5 nm is too thin and may be shortly worn away.

A nitride layer having a thickness of more than 1000 nm increases stress on the nitride layer upon extruding a molding raw material. Thus, cracks may occur in the inner wall surface of the second through hole in the molding section.

In a die for extrusion molding according to claim 6, the nitride layer has a hardness of 1200 to 3000 Hv.

A nitride layer having a hardness of 1200 to 3000 Hv prevents abrasion of the inner wall surface of the second through hole in the molding section even after repeated extrusion molding of molding raw materials. Thus, the life of the die can be further increased.

A nitride layer having a hardness of less than 1200 Hv may not readily achieve the effect of the present invention because of the insufficient hardness.

A nitride layer having a hardness of more than 3000 Hv increases stress on the nitride layer upon extruding a molding raw material. Thus, cracks may occur in the inner wall surface of the second through hole in the molding section.

A die for extrusion molding according to claim 7 is made of a superhard alloy that includes a sintered mixture of tungsten carbide and cobalt, and the nitride layer includes tungsten carbonitride.

If the die for extrusion molding is made of a superhard alloy that includes a sintered mixture of tungsten carbide and cobalt, and the nitride layer includes tungsten carbonitride, the inner wall surface of the second through hole has higher hardness. This prevents abrasion of the inner wall surface of the second through hole in the molding section even after repeated extrusion molding of molding raw materials. Thus, the life of the die can be further increased.

In a die for extrusion molding according to claim 8, each of the slit grooves has a slit width of 30 to 1000 $\mu$m.

The slit width of the slit groove corresponds to the thickness of a cell wall or thickness of an outer peripheral wall of an extrusion molded honeycomb molded body. A slit width of 30 to 1000 $\mu$m enables a honeycomb molded body suitable for a particulate filter that captures particulates in exhaust gas to purify the exhaust gases.

A slit width of less than 30 $\mu$m increases the sites (area) where a molding raw material of unit volume contacts the surface of the slit groove, which may increase abrasion of the surface of the slit groove.

In a die for extrusion molding according to claim 9, the die includes 100 to 500 intersections of the slit grooves per square inch.

If the die includes 100 to 500 intersections of the slit grooves per square inch, a honeycomb molded body suitable for a particulate filter that captures particulates in exhaust gas to purify the exhaust gas can be produced.

If the die includes more than 500 intersections of the slit grooves per square inch, the sites (area) where a molding raw material of unit volume contacts the surfaces of the slit grooves increase, which may increase abrasion of the surfaces of the slit grooves.

In a die for extrusion molding according to claim 10, a molding raw material to be introduced to the raw material supply section includes silicon carbide.

Even if the molding raw material includes silicon carbide, which is very hard, the inner wall surface of the second through hole is less likely to be worn away. Thus, the life of the die can be increased.

A die for extrusion molding according to claim 11 includes a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole, the nitride layer being formed by nitrogen ion implantation.

The nitride layer provided on the inner wall surface of the second through hole enhances the hardness of the inner wall surface of the second through hole. This prevents abrasion of the inner wall surface of the second through hole even after repeated extrusion molding of molding raw materials. Thus, the life of the die can be increased.

In particular, even if the molding raw material consists mainly of hard ingredients, such as silicon carbide powders, the inner wall surface of the second through hole is less likely to be worn away. Thus, the life of the die can be increased.

In a method of producing a die for extrusion molding according to claim 12, the die includes: a first face; a second face formed opposite the first face; a raw material supply section with a first through hole that extends from the first face toward the second face; and a molding section with a second through hole that extends from the second face toward the first face so as to communicate with the first through hole, and the method includes the steps of: machining a material of a die so as to form the material into a die having a predetermined shape, and nitriding for forming a nitride layer by nitrogen ion implantation on an inner wall surface of the second through hole in the molding section of the machined die.

The nitriding step for forming a nitride layer by nitrogen ion implantation enables formation of a uniform nitride layer. In particular, even if the machined die has a complex shape, the nitride layer can be uniformly formed. Formation of the uniform nitride layer enables favorable production of the die for extrusion molding of the present invention.

In a method of producing a die for extrusion molding according to claim 13, the nitriding step enhances the hardness of the inner wall surface of the second through hole in the molding section by 1.2 to 2 times.

If the nitriding step enhances the hardness of the inner wall surface of the second through hole by 1.2 to 2 times, a produced die for extrusion molding includes a second through hole having an inner wall surface that is less likely to be worn away even after repeated extrusion molding of molding raw materials. Thus, a die having a long life can be produced.

If the hardness of the inner wall surface of the second through hole is enhanced by less than 1. 2 times, a formed nitride layer does not have sufficient hardness. Thus, the effect of the present invention may not be adequately achieved.

If the hardness of the inner wall surface of the second through hole is enhanced by more than 2 times, the formed nitride layer has great stress upon extrusion molding a molding raw material through a produced die for extrusion molding. Thus, cracks may occur in the inner wall surface of the second through hole.

An extruder according to claim 14 includes a drum; a die for extrusion molding provided at an end portion of the drum; a screw housed in the drum; and a mesh housed in the drum at a position closer to the end portion than the screw, wherein at least one of the die for extrusion molding, the screw, and the mesh includes a nitride layer provided on a surface thereof.

The surface of the at least one member provided with a nitride layer is less likely to be worn away upon contacting with a molding raw material. Thus, the life of the extruder including the member can be increased.

In particular, even if the molding raw material consists mainly of silicon carbide powders, which are very hard, or the like, the surface of the member is less likely to be worn away. Thus, the life of the extruder including the member can be increased.

A method of producing a honeycomb structured body according to claim 15 includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, wherein the die includes: a first face; a second face formed opposite the first face; a raw material supply section with a first through hole that extends from the first face toward the second face; and a molding section with a second through hole that extends from the second face toward the first face so as to communicate with the first through hole, the molding section including a nitride layer provided on an inner wall surface of the second through hole.

In the method of producing a honeycomb structured body according to claim 15, an increase and variation in the thickness of the cell walls of a honeycomb molded body can be prevented during the step to produce at least one honeycomb molded body. Thus, a honeycomb structured body can be favorably produced.

BRIEF DESCRIPTION OF DRAWINGS

Fig. 1(a) is a cross-sectional view schematically illustrating one example of a die for extrusion molding according to the first embodiment of the present invention. Fig. 1(b) is a partially enlarged view of the die for extrusion molding illustrated in Fig. 1(a).

Fig. 2 is a cross-sectional view schematically illustrating slit grooves when the material of the die for extrusion molding according to the first embodiment of the present invention includes a superhard alloy.

Fig. 3 is a front enlarged view of the die for extrusion molding illustrated in Fig. 1(a).

Fig. 4 is a perspective view schematically illustrating one example of a honeycomb molded body that is extrusion molded through the die for extrusion molding according to the first embodiment of the present invention.

Fig. 5(a) is a perspective view schematically illustrating one example of a honeycomb fired body that is produced using the die for extrusion molding according to the present embodiment. Fig. 5(b) is an A-A line cross-sectional view of the honeycomb fired body illustrated in Fig. 5(a).

Fig. 6 is a perspective view schematically illustrating one example of a honeycomb structured body that is produced using the die for extrusion molding according to the present embodiment.

Fig. 7 is a graph showing results of secondary ion mass spectrometry on the surfaces of slit grooves of the die for extrusion molding produced in Example 1.

Fig. 8 is a perspective view schematically illustrating an image of molding a honeycomb molded body using an extruder that includes the die for extrusion molding according to the first embodiment of the present invention.

DESCRIPTION OF EMBODIMENTS

Embodiments of the present invention will be specifically described below. However, the present invention is not limited to those embodiments, and may be appropriately changed to an extent not changing the gist of the present invention.

(First embodiment)

The following describes the die for extrusion molding according to the first embodiment of the present invention, and the method of producing a die for extrusion molding and the method of producing a honeycomb structured body according to the first embodiment, which is one embodiment of the present invention, with reference to drawings.

First, a die for extrusion molding according to the present embodiment will be described.

The die for extrusion molding of the present embodiment includes a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole.

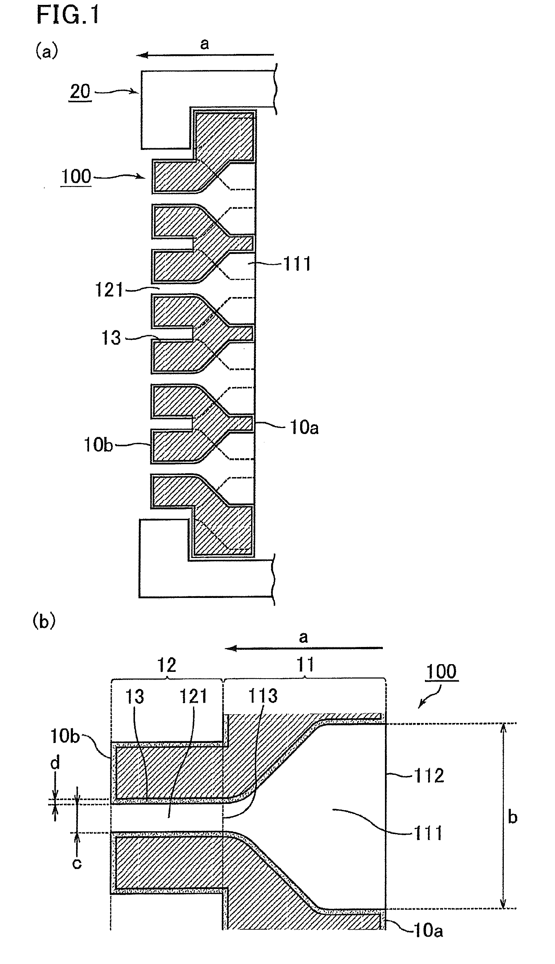

Fig. 1(a) is a cross-sectional view schematically illustrating one example of a die for extrusion molding according to the first embodiment of the present invention. Fig. 1(b) is a partially enlarged view of the die for extrusion molding illustrated in Fig. 1(a).

Fig. 1(a) and Fig. 1(b) are cross-sectional views of a die for extrusion molding illustrated in a direction parallel to the direction of extruding a molding raw material. The arrow "a" in Fig. 1(a) and Fig. 1(b) indicates the direction of extruding a molding raw material.

As shown in Fig. 1(a) and Fig. 1(b), a die for extrusion molding 100 includes a first face 10a; a second face 10b formed opposite the first face 10a; a raw material supply section 11 with a first through hole 111 that extends from the first face 10a toward the second face 10b; and a molding section 12 with a second through hole 121 that extends from the second face 10b toward the first face 10a so as to communicate with the first through hole 111. The molding section 12 includes slit grooves that communicate with a plurality of the second through holes 121, the slit grooves connecting to one another to form a lattice pattern.

The raw material supply section 11 is formed to supply a molding raw material. The molding section 12 is formed to form a molding raw material passed through the raw material supply section 11 into the shape of a honeycomb molded body.

An outer frame 20 for immobilizing the die for extrusion molding 100 may be provided as needed.

In the following description, the inner wall surfaces of the second through holes 121 in the molding section 12 correspond to the surfaces of the slit grooves 12. A nitride layer 13 is formed on the surfaces of the slit grooves 12.

The nitride layer 13 formed on the surfaces of the slit grooves 12 is an essential element of the die for extrusion molding according to the present embodiment. In addition to the essential element, the nitride layer 13 may also be formed on the inner wall surface of the first through hole 111, the first face 10a, the second face 10b, or other parts as shown in the raw material supply section 11 in Fig. 1 (a) and Fig. 1(b).

The nitride layer 13 refers to a layer of a hard nitride compound formed by nitriding a metal surface by nitrogen ion implantation. The nitrogen ion implantation will be specifically described in the description below of a method of producing a die for extrusion molding according to the present embodiment.

The nitride layer 13 has a hardness of preferably 1200 to 3000 Hv, and more preferably 2000 to 2500 Hv. The hardness refers to a Vickers hardness measured in accordance with JIS standard (Standard No. JIS Z 2244).

The nitride layer 13 has a thickness (the length indicated by the double-headed arrow "d" in Fig. 1(b)) of preferably 5 to 1000 nm, and more preferably 10 to 100 nm.

Preferably, the nitride layer 13 having a uniform thickness is formed over the entire surfaces of the slit grooves 12.

The thickness of the nitride layer 13 can be measured, for example, using a secondary ion mass spectrometer (SIMS). The measurement method will be specifically described in examples below.

The die for extrusion molding 100 is preferably made of a superhard alloy that includes a sintered mixture of tungsten carbide and cobalt, a superhard alloy that includes a sintered mixture of tungsten carbide, cobalt, and a trace amount of other particles (for example, TiC, TiN), tool steel, stainless steel, an aluminum alloy, or the like, and more preferably a superhard alloy that includes a sintered mixture of tungsten carbide and cobalt.

A superhard alloy that includes a sintered mixture of tungsten carbide and cobalt usually has a hardness of 1000 to 1500 Hv.

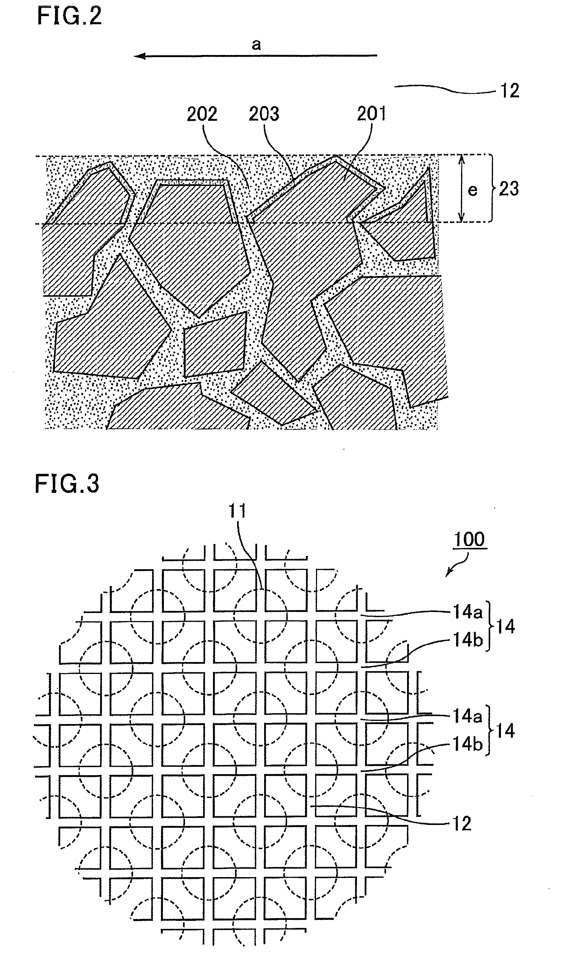

Fig. 2 is a cross-sectional view schematically illustrating slit grooves when the die for extrusion molding according to the first embodiment of the present invention is made of a superhard alloy.

Fig. 2 is a cross-sectional view of a slit groove illustrated in a direction parallel to the direction of extruding a molding raw material. The arrow "a" in Fig. 2 indicates the direction of extruding a molding raw material.

As shown in Fig. 2, the superhard alloy used as the material of the die for extrusion molding includes tungsten carbide particles 201 which are bonded by cobalt 202 mixed as a binder.

The tungsten carbide particles 201 preferably have an average particle size of 0.1 to 10 $\mu$m. The cobalt 202 content is preferably 3 to 20%.

Moreover, as shown in Fig. 2, the surfaces of the tungsten carbide particles 201 are nitrided so that a tungsten carbonitride 203 is formed in the vicinity of the surfaces of the slit grooves 12.

A nitride layer 23 shown in Fig. 2 corresponds to a layer of the tungsten carbonitride 203 formed on the surfaces of the tungsten carbide particles 201, and the nitride layer corresponds to the nitride layer 13 shown in Fig. 1(a) and 1(b). The thickness (the length indicated by the double-headed arrow "e" in Fig. 2) of the nitride layer 23 shown in Fig. 2 corresponds to the thickness (the length indicated by the double-headed arrow "d" in Fig. 1(b)) of the nitride layer 13 shown in Fig. 1(b).

As mentioned earlier, the nitride layer 23 has a thickness (the length indicated by the double-headed arrow "e" in Fig. 2) of preferably 5 to 1000 nm, and more preferably 10 to 100 nm. In other words, the thickness of the nitride layer 23 is much smaller than the average particle size of the tungsten carbide particles 201. Thus, as shown in Fig. 2, the tungsten carbonitride 203 is preferably formed not on the entire surfaces of the tungsten carbide particles 201 but on the surfaces of the tungsten carbide particles 201 only in the vicinity of the surfaces of the slit grooves 12.

The length of the raw material supply section 11 in a direction parallel to the direction of extruding a molding raw material is preferably, but not limited to, 3 to 20 mm.

If the length of the raw material supply section 11 in a direction parallel to the direction of extruding a molding raw material is within the above range, a molding raw material can be readily extrusion molded.

The width (the length indicated by the double-headed arrow "b" in Fig. 1(b)) of the raw material supply section 11 is preferably, but not limited to, 1.0 to 1.5 mm.

If the width of the raw material supply section 11 is within the above range, a molding raw material can be readily extrusion molded.

In the case of the raw material supply section 11 having a round cross section, the width of the raw material supply section 11 refers to the diameter of the round. In the case of the raw material supply section 11 having a polygonal cross section, the width refers to the diameter of a hypothetical circumscribed round touching the vertices of the polygon.

As shown in Fig. 1(b), the raw material supply section 11 further includes a first opening 112 formed at the first face 10a, and a second opening 113 formed at a part where the second through hole 121 communicates with the first through hole 111. The width (the length indicated by the double-headed arrow "b" in Fig. 1(b)) of the raw material supply section 11 decreases from the first opening 112 toward the second opening 113.

The slit grooves 12 each has a slit width (the length indicated by the double-headed arrow "c" in Fig. 1(b)) that corresponds to the thickness of each cell wall or the thickness of the outer peripheral wall of the honeycomb molded body. The slit width is preferably 30 to 1000 $\mu$m, and more preferably 60 to 500 $\mu$m.

The length of the slit grooves 12 in a direction parallel to the direction of extruding a molding raw material is preferably, but not limited to, 1 to 4 mm.

If the length of the slit grooves 12 in a direction parallel to the direction of extruding a molding raw material is within the above range, a molding raw material can be readily extrusion molded.

Fig. 3 is a front enlarged view of the die for extrusion molding illustrated in Fig. 1(a).

As shown in Fig. 3, the slit grooves 12 communicate with the raw material supply sections 11 and form a lattice pattern.

Supposing that points at which the slit grooves 12 intersect are intersections 14, the number of the intersections 14 is preferably 100 to 500 per square inch, and more preferably 200 to 400 per square inch.

Each of the raw material supply sections 11 is usually disposed at an intersection of the slit grooves 12.

Specifically, as shown in Fig. 3, supposing that adjacent ones among the intersections of the slit grooves 12 are intersections 14a and 14b, one of the raw material supply sections 11 is disposed on the intersection 14a.

The molding raw material may be selected depending on the materials of a honeycomb molded body (honeycomb structured body) to be produced.

Examples of the molding raw material include: nitride ceramics, such as aluminum nitride, silicon nitride, boron nitride, or titanium nitride; carbide ceramics, such as silicon carbide, zirconium carbide, titanium carbide, tantalum carbide, or tungsten carbide; and oxide ceramics, such as alumina, zirconia, cordierite, mullite, silica, or aluminum titanate. Silicon carbide is especially preferable.

The following describes a method of producing a die for extrusion molding according to the present embodiment.

The method of producing a die for extrusion molding according to the present embodiment is a method of producing a die for extrusion molding, the die including: a first face; a second face formed opposite the first face; a raw material supply section with a first through hole that extends from the first face toward the second face; and a molding section with a second through hole that extends from the second face toward the first face so as to communicate with the first through hole, the method including the steps of: machining a material of a die so as to form the material into a die having a predetermined shape, and nitriding for forming a nitride layer by nitrogen ion implantation on an inner wall surface of the second through hole in the molding section of the machined die.

First, a machining step is performed for forming a material of a die into a die having a predetermined shape.

Specifically, as shown in Fig. 1 (a) and 1(b), a material of the die is machined to form the first through hole 111 that extends from the first face 10a toward the second face 10b and then form the second through hole 121 that extends from the second face 10b toward the first face 10a so as to communicate with the first through hole 111. The molding section 12 includes slit grooves that communicate with a plurality of the second through holes 121, the slit grooves connecting to one another to form a lattice pattern.

In the following description, the inner wall surfaces of the second through holes 12 in the molding section 12 correspond to the surfaces of the slit grooves 12.

The shapes of the raw material supply sections 11 and the slit grooves 12 are described above, and thus the specific description thereof is omitted.

Examples of the methods for forming the raw material supply sections and the slit grooves include, but not particularly limited to, machining with a cutting tool, such as a drill.

If the die is made of a hard material, such as a superhard alloy, or a die to be produced has a complex shape, examples of the methods include electrical discharge machining.

Next, a nitriding step is performed for forming a nitride layer by nitrogen ion implantation on the surfaces of the slit grooves.

The nitrogen ion implantation herein means a method of applying a negative pulse voltage to a workpiece placed in plasma so as to implant nitrogen ions into the workpiece, so that a nitride layer is formed.

First, a high-frequency power is applied between a device and the die to generate plasma.

Preferably, the output and frequency of the high-frequency power are 0.3 to 2.0 kW and 13.56 MHz, respectively. Preferably, the application time is 100 to 500 $\mu$sec, and a downtime is 50 to 300 $\mu$sec.

Then, a negative high voltage pulse is applied to the die housed in the device in which plasma is generated.

The nitrogen ions in the plasma are accelerated toward the surface of the die so that the nitrogen ions are implanted into the die through the surface. Metals in the vicinity of the surface of the die react with the nitrogen ions and are nitrided to form a nitride layer.

The voltage of the high voltage pulse is preferably -5 to -20 kV. The thickness of a nitride layer can be changed by changing the voltage of the high voltage pulse.

For example, in the case of using a superhard alloy including a sintered mixture of tungsten carbide (WC) and cobalt as the material of the die, the tungsten carbide (WC) reacts with nitrogen ions so that a nitride layer including tungsten carbonitride (WCN) is formed.

The die for extrusion molding according to the present embodiment can be produced through the above steps.

The nitriding step of forming the nitride layer 13 by the nitrogen ion implantation on the surfaces of the slit grooves 12 preferably enhances the hardness of the surfaces of the slit grooves 12 by 1.2 to 2 times.

Lastly, the following describes one example of a method of producing a honeycomb structured body using the die for extrusion molding according to the present embodiment.

The method of producing a honeycomb structured body according to the present embodiment includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, wherein the die includes: a first face; a second face formed opposite the first face; a raw material supply section with a first through hole that extends from the first face toward the second face; and a molding section with a second through hole that extends from the second face toward the first face so as to communicate with the first through hole, the molding section including a nitride layer provided on an inner wall surface of the second through hole.

(1) First, a wet mixture (molding raw material) of ceramic powders and a binder is prepared.

Specifically, ceramic powders, an organic binder, a liquid plasticizer, a lubricant, and water are mixed to prepare a wet mixture for producing a honeycomb molded body.

The ceramic powders may be selected depending on the materials of a honeycomb molded body (honeycomb structured body) to be produced.

Examples of the main component of the materials of the honeycomb molded body include nitride ceramics, such as aluminum nitride, silicon nitride, boron nitride, or titanium nitride; carbide ceramics, such as silicon carbide, zirconium carbide, titanium carbide, tantalum carbide, or tungsten carbide; and oxide ceramics, such as alumina, zirconia, cordierite, mullite, silica, or aluminum titanate.

The main component of the materials of the honeycomb molded body is preferably a non-oxide ceramic, and particularly preferably silicon carbide because such materials have excellent heat resistance, mechanical strength, thermal conductivity, or the like.

Herein, the expression "the main component is silicon carbide" means that the silicon carbide content in the ceramic powders is not less than 60% by weight. In the case where the main component is silicon carbide, the main component may also include silicon-bonded silicon carbide. The same is true to the case where the main component is a component of the materials other than silicon carbide.

(2) Next, the wet mixture (molding raw material) is extrusion molded into a honeycomb molded body having a predetermined shape.

The die for extrusion molding according to the present embodiment is used for the extrusion molding.

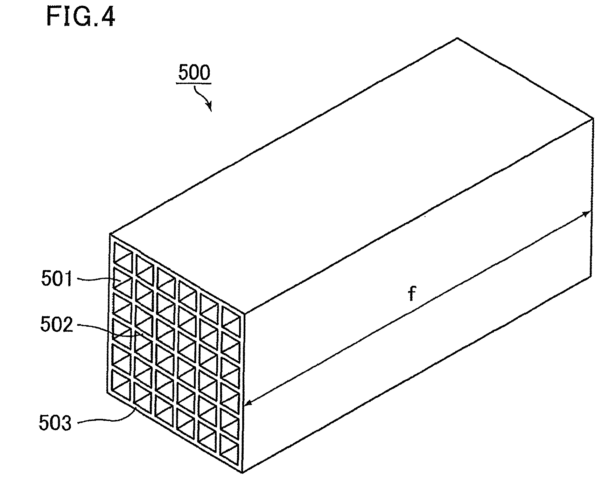

Fig. 4 is a perspective view schematically illustrating one example of a honeycomb molded body that is extrusion molded through the die for extrusion molding according to the first embodiment of the present invention. A honeycomb molded body 500 shown in Fig. 4 includes a large number of cells 501 that are separated by cell walls 502 and arranged in parallel with one another in a longitudinal direction (the direction of the double-headed arrow "f" in Fig. 4). An outer peripheral wall 503 is formed on the circumference of the cells 501 and the cell walls 502.

(3) Thereafter, the honeycomb molded body is dried using a drier, such as a microwave drier, a hot air drier, a dielectric drier, a reduced pressure drier, a vacuum drier, or a freeze drier, to thereby produce a dried honeycomb dried body.

The dried honeycomb molded body is degreased (for example, at 200 to 500°C) and fired (for example, at 1400 to 2300°C) under predetermined conditions.

Through the above steps, a honeycomb fired body including: a large number of cells that are separated by cell walls and arranged in parallel with one another in a longitudinal direction; and an outer peripheral wall provided on the circumference thereof can be produced.

The degreasing and firing of the dried honeycomb molded body may be performed under conventional conditions for producing honeycomb fired bodies.

The method of producing a honeycomb structured body using the die for extrusion molding according to the present embodiment enables production of a honeycomb fired body in which one of end portions of each cell is plugged. In this case, after the drying in the step (3), predetermined end portions of the cells of the dried honeycomb molded body are filled with a predetermined amount of a plug material paste, which becomes a plug, to plug the cells. Then, the honeycomb molded body is degreased and fired as described above so that a honeycomb fired body in which one of end portions of each cell is plugged can be produced.

The wet mixture may be used as the plug material paste.

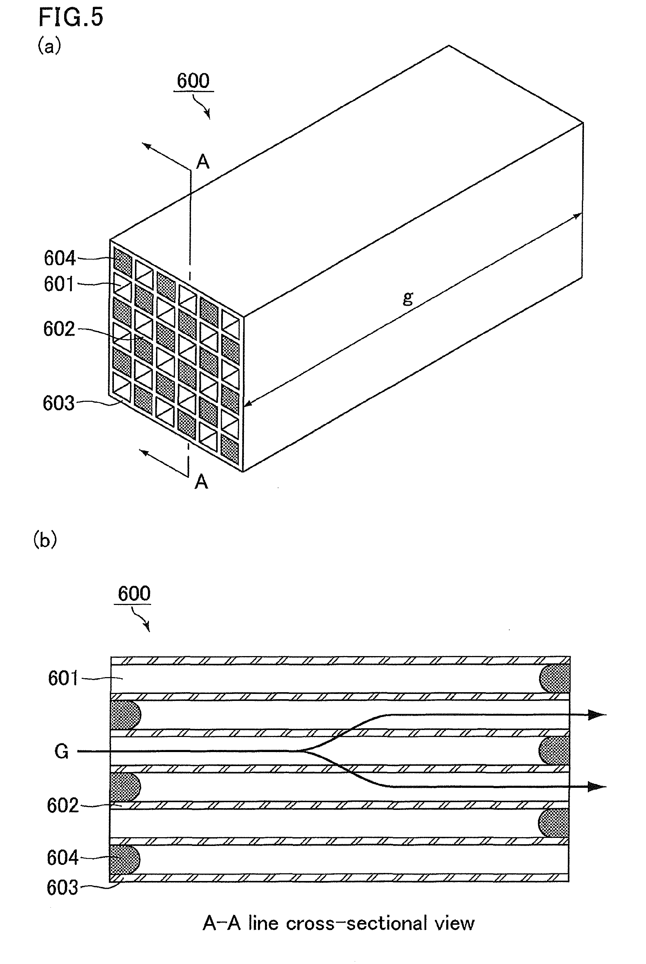

Fig. 5(a) is a perspective view schematically illustrating one example of a honeycomb fired body that is produced using the die for extrusion molding according to the present embodiment. Fig. 5(b) is an A-A line cross-sectional view of the honeycomb fired body illustrated in Fig. 5(a).

A honeycomb fired body 600 shown in Fig. 5(a) and Fig. 5(b) includes: a large number of cells 601 that are separated by cell walls 602 and arranged in parallel with one another in a longitudinal direction (the direction of an arrow "g" in Fig. 5(a)); and an outer peripheral wall 603 provided on the circumference of the cells 601 and the cell walls 602.

One of the end portions of each cell 601 is plugged with a plug 604.

Thus, exhaust gas G (exhaust gas is indicated by G, and the flow of the exhaust gas is indicated by an arrow in Fig. 5 (b)) which enters one of the cells 601 with one end opened will always pass through the cell wall 602 separating the cells 601 to flow out from another one of the cells 601 with an another end opened. PMs or the like in exhaust gas are captured when the exhaust gas G passes through the cell walls 602. The cell walls 602 thus function as a filter.

As mentioned earlier, a honeycomb structured body including the honeycomb fired body in which one of the end portions of each cell is plugged can be favorably used as a ceramic filter. Furthermore, a honeycomb structured body including a honeycomb fired body in which none of the end portions of the cells is plugged can be favorably used as a catalyst carrier.

(4) Next, a ceramic block of at least one honeycomb fired body is produced.

The following describes one example of a method of producing a ceramic block of a plurality of honeycomb fired bodies which are combined with adhesive layers.

First, an adhesive paste, which becomes an adhesive layer, is applied to a predetermined side face of one of the honeycomb fired bodies to form an adhesive paste layer. Another honeycomb fired body is then stacked on the adhesive paste layer. Through repetition of this process, an aggregate of the honeycomb fired bodies is produced.

Next, the aggregate of the honeycomb fired bodies is heated to dry and solidify the adhesive paste layers so that a ceramic block is produced.

The adhesive paste is, for example, one including an inorganic binder, an organic binder, and inorganic particles. The adhesive paste may also include inorganic fibers and/or a whisker.

(5) Thereafter, a ceramic block is machined.

Specifically, the outer periphery of the ceramic block is machined with a cutter, such as a diamond cutter, to produce a ceramic block with a round pillar-shaped outer periphery.

(6) Next, an outer periphery coating material paste is applied to an outer peripheral surface of the round pillar-shaped ceramic block, and is then solidified by drying to form an outer periphery coat layer.

The adhesive paste may be used as the outer periphery coating material paste. The outer periphery coating material paste may be a paste having different composition from that of the adhesive paste.

The outer periphery coat layer is not essential, but may be provided as needed.

Through the above steps, a honeycomb structured body can be produced.

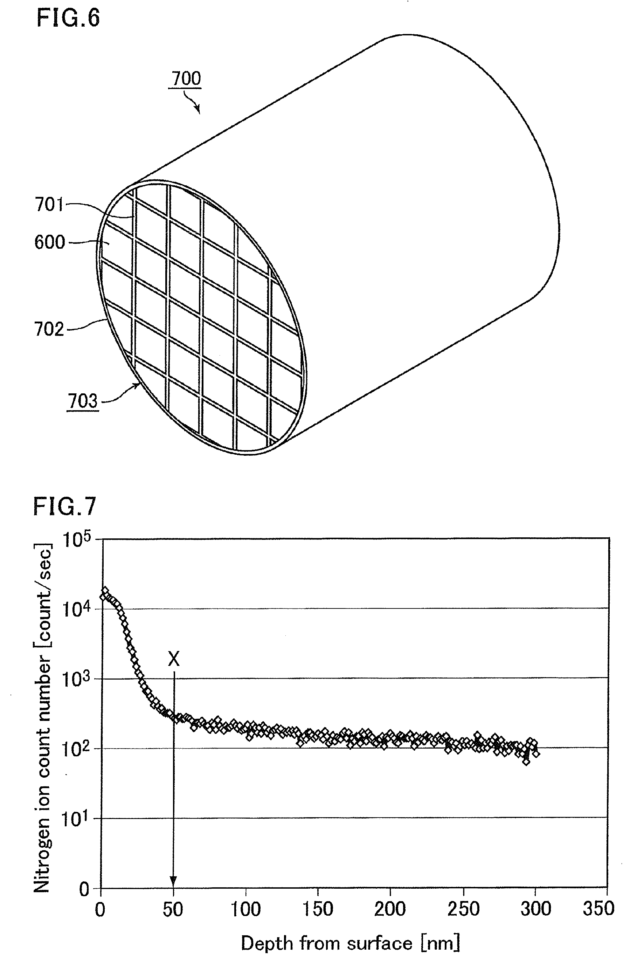

Fig. 6 is a perspective view schematically illustrating one example of a honeycomb structured body that is produced using the die for extrusion molding according to the present embodiment.

A honeycomb structured body 700 shown in Fig. 6 includes a ceramic block 703 and an outer periphery coat layer 702 formed on an outer periphery of the ceramic block 703. The ceramic block includes a plurality of honeycomb fired bodies 600 which are combined with one another with adhesive layers 701 provided therebetween. The outer periphery coat layer may be formed as needed.

The honeycomb structured body including a plurality of honeycomb fired bodies combined is also referred to as an aggregated honeycomb structured body.

The effects of the die for extrusion molding and the method of producing a die for extrusion molding according to the present embodiment are listed below.

(1) The die for extrusion molding according to the present embodiment includes a nitride layer provided on the surfaces of the slit grooves. The nitride layer provided on the surfaces of the slit grooves enhances the hardness of the surfaces of the slit grooves.

This prevents abrasion of the surfaces of the slit grooves even after repeated extrusion molding of molding raw materials. Thus, the life of the die can be increased.

(2) In the die for extrusion molding according to the present embodiment, the nitride layer has a thickness of 5 to 1000 nm.

If the nitride layer has a thickness within the above range, the surfaces of the slit grooves can long maintain the abrasion resistance. Thus, the life of the die can be further increased.

(3) In the die for extrusion molding according to the present embodiment, the nitride layer has a hardness of 1200 to 3000 Hv. A nitride layer having a hardness within the above range prevents abrasion of the surfaces of the slit grooves even after repeated extrusion molding of molding raw materials. Thus, the life of the die can be further increased.

(4) The material of the die for extrusion molding according to the present embodiment includes a superhard alloy that includes a sintered mixture of tungsten carbide and cobalt, and the nitride layer includes tungsten carbonitride.

If the die for extrusion molding is made of the above raw materials, the surfaces of the slit grooves have higher hardness. This prevents abrasion of the surfaces of the slit grooves even after repeated extrusion molding of molding raw materials. Thus, the life of the die can be further increased.

(5) In the die for extrusion molding according to the present embodiment, the slit grooves each has a slit width of

30 to 1000 μm. A slit width within the above range enables a honeycomb molded body that suitably functions as a particulate filter capable of capturing particulates in exhaust gas to purify the exhaust gas.

(6) In the die for extrusion molding according to the present embodiment, the slit grooves are in a lattice pattern with 100 to 500 intersections per square inch. Slit grooves with the number of intersections within the above range enable a honeycomb molded body that suitably functions as a particulate filter capable of capturing particulates in exhaust gas to purify the exhaust gas.

(7) In the die for extrusion molding according to the present embodiment, the molding raw material includes silicon carbide. Even if the molding raw material includes silicon carbide, which is very hard, the surfaces of the slit grooves are less likely to be worn away. Thus, the life of the die can be increased.

(8) In the die for extrusion molding according to the present embodiment, the raw material supply section further includes a first opening formed at the first face and a second opening formed at a part where the second through hole communicates with the first through hole. Also, the width of the raw material supply section decreases from the first opening toward the second opening.

If the width of the raw material supply section decreases from the first opening toward the second opening, a molding raw material readily flows from the raw material supply section to the molding section. Thus, the molding raw material is prevented from clogging in the die for extrusion molding.

(9) The method of producing a die for extrusion molding according to the present embodiment includes a nitriding step to form a nitride layer by nitrogen ion implantation on the surfaces of the slit grooves. This nitriding step enables formation of a uniform nitride layer. In particular, even if the machined die has a complex shape, the nitride layer can be uniformly formed. Formation of the uniform nitride layer enables favorable production of the die for extrusion molding according to the present embodiment.

(10) In the method of producing a die for extrusion molding according to the present embodiment, the nitriding step enhances the hardness of the surfaces of the slit grooves by 1.2 to 2 times. The enhancement of the hardness of the surfaces of the slit grooves by 1.2 to 2 times enables production of a die for extrusion molding in which abrasion of the surfaces of the slit grooves is less likely to occur even after repeated extrusion molding of molding raw materials. Thus, a die having a long life can be produced.

EXAMPLES

The following examples more specifically describe the present embodiment. The present invention is not limited to the examples.

Example 1 more specifically describes the first embodiment of the present invention shown in Figs. 1 (a) and 1(b), Fig. 2, and Fig. 3.

(Example 1)

A superhard alloy that includes a sintered mixture of tungsten carbide and cobalt was prepared as a material of a die. The material of a die had a hardness of 1200 Hv.

The material of a die was subjected to blade machining so as to form the material into the shape shown in Fig. 1(a). Specifically, the outer periphery was machined to form a protruded second face where a second through hole was to be formed. Then, a first through hole having a round cross section was formed from the first face toward the second face. Next, the second through hole was formed from the second face toward the first face so as to communicate with the first through hole.

The blade machining was performed using a slicer (SPG-150, produced by NAGASE INTEGREX Co., Ltd.) under the condition of a blade width of 0.23 mm, the number of revolution of 8150 rpm, and a feed rate of 4 mm/min.

The formed slit grooves each had a slit width of 235 μm.

The second through holes constituting the slit grooves were in a lattice pattern and communicated with the first through holes constituting the raw material supply sections. The number of cross sections of the slit grooves was 300 per square inch.

As shown in Fig. 3, supposing that adjacent intersections of the slit grooves are intersections 14a and 14b, one of the raw material supply sections is disposed on the intersection 14a.

Next, a high voltage pulse of -18 kV was applied for 60 minutes to a die housed in a device in which plasma was generated to thereby form a nitride layer.

A die for extrusion molding was produced through the above steps.

The die for extrusion molding produced in Example 1 was measured for the thickness of the nitride layer, the hardness of the surfaces of the slit grooves, and the abrasion loss in the slit width as described below.

All the above measurement items were measured at a part located 30 μm, in the depth direction, from the second face where the second through hole was formed. Moreover, the items were each measured at any 10 sites of the slit grooves which correspond to the cell walls of a honeycomb molded body. Table 1 shows the average of the values measured at the 10 sites for each of the items.

(Measurement of thickness of nitride layer)

The thickness of the nitride layer provided on the surfaces of the slit grooves was measured using a secondary ion mass spectrometer (SIMS) (ADEPT-1010, produced by ULVAC-PHI. INC.) under the condition of a primary ion species of Cs+ion and a primary ion acceleration voltage of 3.0 kV.

The secondary ion mass spectrometry is a method for determining the elements existing on the surface of a sample by sputtering the surface of the sample with a primary ion and then analyzing the mass of a secondary ion released from the surface of the sample into a vacuum upon the sputtering. The surface of the sample is chipped off the sputtering, which enables elemental analysis in the depth direction.

Fig. 7 is a graph showing the results of a secondary ion mass spectrometry on the surface of the slit groove of the die for extrusion molding produced in Example 1.

In Fig. 7, the horizontal axis indicates the depth from the surface of the slit groove; and the vertical axis indicates the count number of nitrogen ions (secondary ions) released from the surface of the slit groove. In this example, the depth of a site X from the surface of the slit groove was considered as the thickness of the nitride layer provided on the surface of the slit groove. The site X was a site where almost no change was found in the number of nitrogen ions released from the surface of the slit groove.

(Measurement of hardness of surfaces of slit grooves)

The hardness of the surfaces of the slit grooves was measured using a Vickers hardness meter (HM-221, produced by Mitsutoyo Corporation).

A Vickers hardness test is performed as follows. A needle-shaped object having a diamond-shaped tip (angle between faces: 136°), called a diamond indenter, is pressed at a test force F (kgf) to the surface of a substrate to be measured for the hardness. The surface area S (mm$^2$) of a resulting impression is calculated from the length d (average of the two-direction diagonal lines) of the diagonal lines. The hardness can be calculated from the length d, the surface area S, and the test force F (kgf) based on the following formula.

$$\text{Hardness (Hv)} = F \text{ (kgf)}/S \text{ (mm}^2) = 0.1892F \text{ (kgf)}/d^2 \text{ (mm}^2)$$

(Measurement of abrasion loss in slit width)

First, flow finishing of the surfaces of the slit grooves was performed. The flow finishing was performed by repeating uniform introduction of an abrasive into the raw material supply sections and extruding the abrasive from the slit grooves. The abrasive used was silicon carbide having a grain size #320 (average particle size: 46.2 μm). The finishing pressure was 6 MPa; the finishing temperature was 30°C; and the finishing time was 24 hours.

Then, the abrasion loss in the slit width was measured using a sizer (UMAP 302, produced by Mitsutoyo Corporation).

(Comparative Example 1)

In Comparative Example 1, a die for extrusion molding was produced in the same manner as in Example 1, except that the nitriding step of forming a nitride layer on the surfaces of the slit grooves was not performed. The hardness of the surfaces of the slit grooves and the abrasion loss in the slit width were measured. Table 1 shows the results of the measurements.

[Table 1]

|  | Thickness of nitride layer (nm) | Hardness of surfaces of slit grooves (Hv) | Abrasion loss in slit width (μm/h) |
|---|---|---|---|
| Example 1 | 50 | 2300 | 0.01 |
| Comparative Example 1 | - | 1200 | 0.12 |

The results in Table 1 indicate that the hardness of the surfaces of the slit grooves is higher and the abrasion loss in the slit width is smaller in the die produced in Example 1 in which a nitride layer is formed on the surfaces of the slit grooves than the hardness and the abrasion loss in the die produced in Comparative Example 1 in which no nitride layer is formed on the surfaces of the slit grooves. Thus, the life of the die produced in Example 1 in which a nitride layer is formed on the surfaces of the slit grooves can be increased.

(Other embodiments)

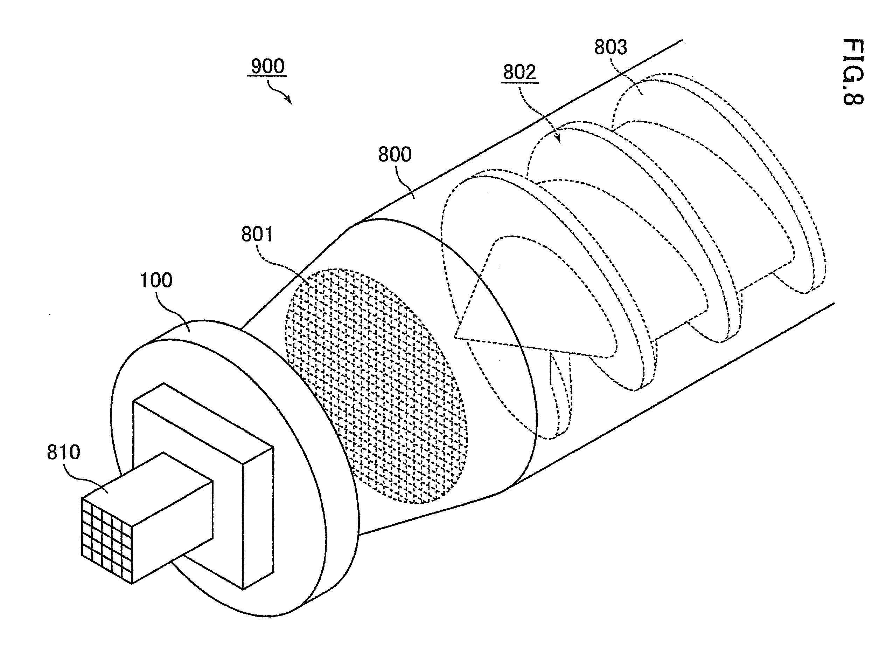

Fig. 8 is a perspective view schematically illustrating an image of molding a honeycomb molded body using an extruder that includes the die for extrusion molding according to the first embodiment of the present invention.

An extruder 900 shown in Fig. 8 includes a drum 800, a die for extrusion molding 100 provided at an end portion of the drum 800; a screw 802 housed in the drum 800; and a mesh 801 housed in the drum 800 at a position closer to the end portion than the screw 802.

The screw 802 is provided to extrude a molding raw material. The screw 802 may have any shape but preferably includes a blade 803.

The mesh 801 is provided to filter coarse foreign substances in molding raw materials. The mesh 801 may have any shape but preferably has a thin sheet shape.

Examples of the material of the screw 802 and the mesh 801 include stainless steel and hard chromium plating.

The die for extrusion molding according to the first embodiment of the present invention includes a nitride layer provided on the surfaces of the slit grooves. The nitride layer is provided not exclusively on the surfaces of the slit grooves but may be provided on the surface of at least one of the die for extrusion molding 100, the screw 802, and the mesh 801.

The nitride layer provided on the screw 802 or the mesh 801 may be formed in the same manner as in the nitriding step described in the method of producing the die for extrusion molding according to the first embodiment of the present invention.

For example, in the case where the screw 802 or the mesh 801 is made of stainless steel, a nitride layer including nitriding steel is formed.

The honeycomb structured body produced using the die for extrusion molding according to the first embodiment of the present invention is an aggregated honeycomb structured body but may be a honeycomb structured body (integrated honeycomb structured body) including a single honeycomb fired body.

For producing an integrated honeycomb structured body, a honeycomb molded body is produced in the same manner as in the first embodiment of the present invention, except that a honeycomb molded body to be extrusion molded is larger than and has a different profile from the honeycomb molded body described in the first embodiment of the present invention.

In other words, the honeycomb molded body may be produced using a die for extrusion molding that has the same structure as that of the die for extrusion molding according to the first embodiment of the present invention, and has a cross-sectional shape corresponding to the shape of the honeycomb molded body to be obtained.

The other steps are the same as those described in the method of producing a honeycomb structured body according to the first embodiment of the present invention. Since the honeycomb structured body includes a single honeycomb fired body, production of an aggregate of the honeycomb fired bodies is not necessary. In the case of producing a round pillar-shaped honeycomb molded body, machining of the outer periphery of the ceramic block is not necessary.

In the die for extrusion molding according to the embodiments of the present invention, the raw material supply section in the die may have any shape. Examples of the cross-sectional shape of the raw material supply section parallel to the direction of extruding a molding raw material include a rectangular shape, a tapered shape, and a trapezoidal shape.

A tapered cross-sectional shape is especially preferable for easy extrusion of a molding raw material.

Similarly, in the die for extrusion molding according to the embodiments of the present invention, the slit groove of the die may have any shape. Examples of the cross-sectional shape of the slit groove parallel to the direction of extruding a molding raw material include a rectangular shape and a tapered shape.

A rectangular cross-sectional shape is especially preferable for easy formation of the slit grooves.

The essential feature of the die for extrusion molding of the present invention is that the die includes: a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole.

Moreover, the essential feature of the die for extrusion molding of the present invention is that the die includes: a first face; a second face formed opposite the first face; a raw material supply section with a first through hole that extends from the first face toward the second face; and a molding section with a second through hole that extends from the second face toward the first face so as to communicate with the first through hole, wherein the molding section includes a nitride layer provided on an inner wall surface of the second through hole, the nitride layer being formed by nitrogen ion implantation.

The essential feature of the method of producing a die for extrusion molding of the present invention is that the die includes: a first face; a second face formed opposite the first face; a raw material supply section with a first through hole that extends from the first face toward the second face; and a molding section with a second through hole that extends from the second face toward the first face so as to communicate with the first through hole, and the method includes the steps of: machining a material of a die so as to form the material into a die having a predetermined shape, and nitriding for forming a nitride layer by nitrogen ion implantation on an inner wall surface of the second through hole in the molding section of the machined die.

The essential feature of the extruder of the present invention is that the extruder includes: a drum; a die for extrusion molding provided at an end portion of the drum; a screw housed in the drum; and a mesh housed in the drum at a position closer to the end portion than the screw, wherein at least one of the die for extrusion molding, the screw, and the mesh includes a nitride layer provided on a surface thereof.

The essential feature of the method of producing a honeycomb structured body of the present invention is that the method includes the steps of: extrusion molding a molding raw material through a die for extrusion molding to produce at least one honeycomb molded body that includes a large number of cells, the cells being separated by cell walls and arranged in parallel with one another in a longitudinal direction; firing the at least one honeycomb molded body to produce at least one honeycomb fired body; and producing a ceramic block of the at least one honeycomb fired body, wherein the die includes: a first face; a second face formed opposite the first face; a raw material supply section with a first through hole that extends from the first face toward the second face; and a molding section with a second through hole that extends from the second face toward the first face so as to communicate with the first through hole, the molding section including a nitride layer provided on an inner wall surface of the second through hole.

Desired effects can be obtained by appropriately combining the essential features with the various structures (for example, the shape of the raw material supply sections, the shape of the slit grooves, or the like) mentioned in detail in the above description of the first embodiment of the present invention and other embodiments of the present invention.

REFERENCE SIGNS LIST

| | |
|---|---|
| 10a | First face |
| 10b | Second face |
| 11 | Raw material supply section |
| 12 | Molding section (slit groove) |
| 13, 23 | Nitride layer |
| 14 (14a, 14b) | Intersections of slit grooves |
| 100 | Die for extrusion molding (die) |
| 111 | First through hole |
| 112 | First opening |
| 113 | Second opening |
| 121 | Second through hole |
| 500 | Honeycomb molded body |
| 501, 601 | Cell |
| 502, 602 | Cell wall |
| 600 | Honeycomb fired body |
| 700 | Honeycomb structured body |
| 703 | Ceramic block |
| 800 | Drum |
| 801 | Mesh |
| 802 | Screw |
| 900 | Extruder |

**Claims**

1. A die for extrusion molding comprising:

    a first face;

a second face formed opposite the first face;
a raw material supply section with a first through hole that extends from the first face toward the second face; and
a molding section with a second through hole that extends from the second face toward the first face so as to communicate with the first through hole,
wherein the molding section comprises a nitride layer provided on an inner wall surface of the second through hole.

2. The die according to claim 1,
wherein the raw material supply section further comprises a first opening formed at the first face and a second opening formed at a part where the second through hole communicates with the first through hole, and
the width of the raw material supply section decreases from the first opening toward the second opening.

3. The die according to claim 1 or 2,
wherein the molding section comprises slit grooves that communicate with a plurality of the second through holes, the slit grooves connecting to one another to form a lattice pattern.

4. The die according to any one of claims 1 to 3,
wherein the raw material supply section further comprises a nitride layer provided on an inner wall surface of the first through hole.

5. The die according to any one of claims 1 to 4,
wherein the nitride layer has a thickness of 5 to 1000 nm.

6. The die according to any one of claims 1 to 5,
wherein the nitride layer has a hardness of 1200 to 3000 Hv.

7. The die according to any one of claims 1 to 6,
wherein the die is made of a superhard alloy that comprises a sintered mixture of tungsten carbide and cobalt, and the nitride layer comprises carbonitride tungsten.

8. The die according to any one of claims 3 to 7,
wherein each of the slit grooves has a slit width of 30 to 1000 $\mu$m.

9. The die according to any one of claims 3 to 8,
wherein the die includes 100 to 500 intersections of the slit grooves per square inch.

10. The die according to any one of claims 1 to 9,
wherein a molding raw material to be introduced to the raw material supply section comprises silicon carbide.

11. A die for extrusion molding comprising:

a first face;
a second face formed opposite the first face;
a raw material supply section with a first through hole that extends from the first face toward the second face; and
a molding section with a second through hole that extends from the second face toward the first face so as to communicate with the first through hole,
wherein the molding section comprises a nitride layer provided on an inner wall surface of the second through hole, the nitride layer being formed by nitrogen ion implantation.

12. A method of producing a die for extrusion molding, the die comprising:

a first face;
a second face formed opposite the first face;
a raw material supply section with a first through hole that extends from the first face toward the second face; and
a molding section with a second through hole that extends from the second face toward the first face so as to communicate with the first through hole,
the method comprising the steps of:
machining a material of a die so as to form the material into a die having a predetermined shape, and

nitriding for forming a nitride layer by nitrogen ion implantation on an inner wall surface of the second through hole in the molding section of the machined die.

13. The method according to claim 12,
wherein the nitriding step enhances the hardness of the inner wall surface of the second through hole in the molding section by 1.2 to 2 times.

14. An extruder comprising:

a drum;
a die for extrusion molding provided at an end portion of the drum;
a screw housed in the drum; and
a mesh housed in the drum at a position closer to the end portion than the screw,
wherein at least one of the die for extrusion molding, the screw, and the mesh comprises a nitride layer provided on a surface thereof.

15. A method of producing a honeycomb structured body comprising the steps of:

extrusion molding a molding raw material through a die for extrusion molding to produce at least one honeycomb molded body that comprises a large number of cells, the cells being separated by cell walls and arranged in parallel with one another in a longitudinal direction;
firing the at least one honeycomb molded body to produce at least one honeycomb fired body; and
producing a ceramic block of the at least one honeycomb fired body,
wherein the die comprises:

a first face;
a second face formed opposite the first face;
a raw material supply section with a first through hole that extends from the first face toward the second face; and
a molding section with a second through hole that extends from the second face toward the first face so as to communicate with the first through hole, the molding section comprising a nitride layer provided on an inner wall surface of the second through hole.

# FIG.1

(a)

(b)

## FIG.2

## FIG.3

## FIG.4

500

501
502
503

f

# FIG.5

(a)

600

604
601
602

603

g

A

A

(b)

600

601

G

602

604
603

A-A line cross-sectional view

## FIG.6

## FIG.7

FIG.8

| | International application No. |
|---|---|
| | PCT/JP2012/058360 |

**A. CLASSIFICATION OF SUBJECT MATTER**
*B28B3/26*(2006.01)i, *C23C14/06*(2006.01)i, *C23C14/48*(2006.01)i

According to International Patent Classification (IPC) or to both national classification and IPC

**B. FIELDS SEARCHED**

Minimum documentation searched (classification system followed by classification symbols)
B28B3/26, C23C14/06, C23C14/48

Documentation searched other than minimum documentation to the extent that such documents are included in the fields searched
Jitsuyo Shinan Koho          1922–1996   Jitsuyo Shinan Toroku Koho   1996–2012
Kokai Jitsuyo Shinan Koho    1971–2012   Toroku Jitsuyo Shinan Koho   1994–2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2008-188795 A  (Denso Corp.),<br>21 August 2008 (21.08.2008),<br>claims; paragraphs [0018] to [0025], [0032],<br>[0033]; fig. 1 to 5<br>(Family: none) | 1-4,8,14,15<br>9,10<br>5-7,11-13 |
| X<br>Y<br>A | JP 2009-196251 A  (Denso Corp.),<br>03 September 2009 (03.09.2009),<br>paragraphs [0054] to [0061]; fig. 13<br>(Family: none) | 1-4,14,15<br>8-10<br>5-7,11-13 |
| X<br>Y<br>A | JP 2009-196252 A  (Denso Corp.),<br>03 September 2009 (03.09.2009),<br>paragraphs [0049] to [0056]; fig. 11<br>(Family: none) | 1-4,14,15<br>8-10<br>5-7,11-13 |

☒ Further documents are listed in the continuation of Box C.      ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 19 June, 2012 (19.06.12) | 26 June, 2012 (26.06.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

| | INTERNATIONAL SEARCH REPORT | International application No. |
|---|---|---|
| | | PCT/JP2012/058360 |

C (Continuation).    DOCUMENTS CONSIDERED TO BE RELEVANT

| Category* | Citation of document, with indication, where appropriate, of the relevant passages | Relevant to claim No. |
|---|---|---|
| Y<br>A | JP 2011-194789 A  (NGK Insulators, Ltd.),<br>06 October 2011 (06.10.2011),<br>paragraphs [0029], [0033], [0042] to [0045]<br>& EP 2368681 A2 | 8,9<br>1-7,10-15 |
| Y<br>A | JP 2010-24518 A  (Ibiden Engineering Co., Ltd.),<br>04 February 2010 (04.02.2010),<br>paragraph [0002]<br>& EP 2305857 A1          & WO 2010/010860 A1 | 10<br>1-9,11-15 |

Form PCT/ISA/210 (continuation of second sheet) (July 2009)

23

# EP 2 832 514 A1

<table>
<tr><td>**INTERNATIONAL SEARCH REPORT**</td><td>International application No.<br>PCT/JP2012/058360</td></tr>
</table>

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

```
     The invention of claim 1 does not have novelty and a special technical
feature since the invention is disclosed in the following document 1, and
consequently, the invention of claim 1 does not comply with the requirement
of unity.
     The inventions of claims indicated below are relevant to a main invention
group.
     Claims 1-10
     Document 1: JP 2008-188795 A
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**REFERENCES CITED IN THE DESCRIPTION**

**Patent documents cited in the description**

• JP H05131425 A